(19) Europäisches Patentamt
European Patent Office
Office européen des brevets

(11) **EP 2 639 914 B1**

(12) **EUROPEAN PATENT SPECIFICATION**

(45) Date of publication and mention
of the grant of the patent:
**22.07.2015 Bulletin 2015/30**

(51) Int Cl.:
*H02H 3/38* *(2006.01)*     *H02H 3/16* *(2006.01)*
*G01R 31/08* *(2006.01)*

(21) Application number: **12159868.4**

(22) Date of filing: **16.03.2012**

(54) **Method and apparatus for adapting earth-fault protection settings in a three-phase electric network**

Verfahren und Vorrichtung zum Anpassen einer Erdfehlerschutzeinstellung in einem Dreiphasen-Elektronetzwerk

Procédé et appareil pour adapter des paramètres de protection contre les défauts de terre dans un réseau électrique triphasé

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.09.2013 Bulletin 2013/38**

(73) Proprietor: **ABB Technology AG**
**8050 Zürich (CH)**

(72) Inventors:
• **Wahlroos, Ari**
**00380 Helsinki (FI)**
• **Altonen, Janne**
**00380 Helsinki (FI)**

(74) Representative: **Kolster Oy Ab**
**Iso Roobertinkatu 23**
**PO Box 148**
**00121 Helsinki (FI)**

(56) References cited:
**EP-A1- 2 192 416**     **EP-A1- 2 375 525**
**WO-A2-2006/130722**

**Description**

FIELD OF THE INVENTION

The present invention relates to adapting earth-fault protection settings in a three-phase electric network.

BACKGROUND OF THE INVENTION

In general terms, directional earth-fault protection may be based on monitoring simultaneously two conditions of a directional quantity:

- Direction
- Magnitude

Operation conditions for the directional earth-fault protection are met when both of the above-mentioned conditions are fulfilled simultaneously: the direction matches a set operation direction and the magnitude of the monitored quantity exceeds a set operation threshold. There may be one or several monitored quantities whose magnitudes are monitored and which must exceed set threshold limits.

A typical arrangement for the directional earth-fault protection in a high impedance earthed network is such that a general fault indication is obtained, when the magnitude of a fundamental frequency component of a residual voltage exceeds a set threshold level. This level should be set above the highest residual voltage $\overline{U}o$ level encountered in the system during a healthy state in any operation conditions. It should be noted that the Uo-setting defines the fundamental sensitivity of the protection and the value depends on the neutral earthing method applied, i.e. it may be different for e.g. an unearthed network and a compensated network.

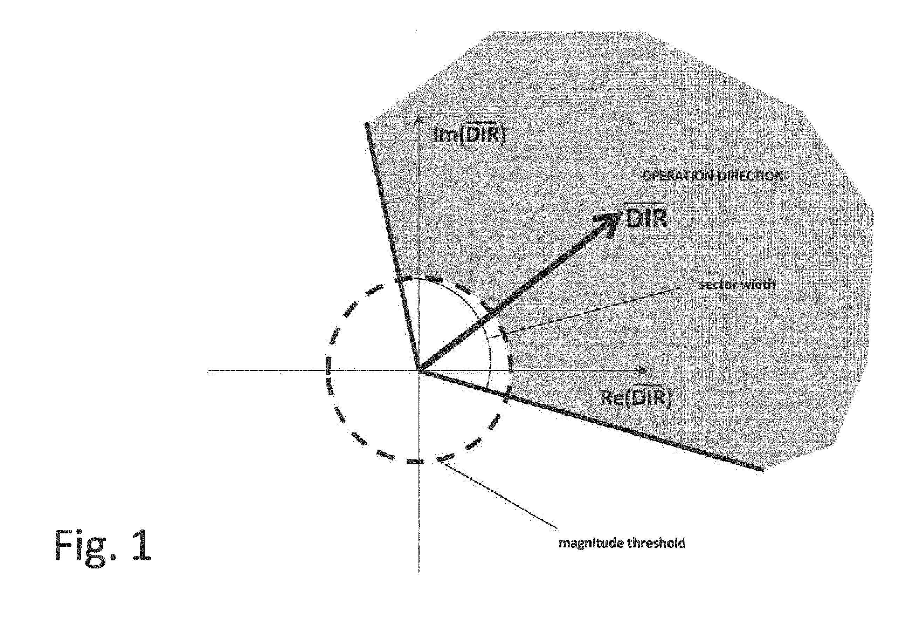

After a general fault detection, the directionality of the fault is evaluated (i.e. to determine if the fault is either inside or outside the protected feeder). For this a directional characteristic may be used, which can be presented on a complex-plane with a real axis and an imaginary axis. The electrical quantity defining the directionality (e.g. power, current or admittance) is presented in the diagram as a phasor (here denoted as $\overline{DIR}$) with a real part and an imaginary part (or equivalently with a magnitude and a phase angle) pointing to a specific direction from the origin (0,0). This phasor is compared with operation sector boundary lines e.g. as illustrated in Figure 1. Operation is achieved when both the directional and magnitude conditions are simultaneously fulfilled.

The problem with the above method is that if the neutral earthing method of the system changes, e.g. when an arc-suppression (Petersen) coil or an neutral earthing resistor is switched on or off in the network, the directional characteristic and the applicable settings have to be changed immediately. For example, in case the network neutral point is earthed through an arc-suppression coil and an locosphi-criterion is used for the directional earth-fault detection, the operation condition should be changed from locos to losin, if the arc-suppression coil becomes switched off. Simultaneously, all other relevant settings affecting the earth-fault protection should preferably be changed.

Conventionally only an automated (not automatic) change of earth-fault protection settings has been possible. The automated change is based on monitoring the state of the arc-suppression coil or an earthing resistor switch and requires that this information be transmitted to the relay. The drawback of the automated change is that it increases the complexity of the system by e.g. requiring an auxiliary wiring and thus involves additional costs. In some cases due to physical distances and non-availability of a communication path, such an automated system may not even be possible.

Document EP2192416 which forms the preamble of claims 1 and 7, discloses a method and an apparatus for detecting a phase-to-earth fault on a three-phase electric line of an electric network. The described solution is based on utilizing zero sequence currents and voltages before an earth fault and during the earth fault for determining a neutral admittance, and comparing the determined neutral admittance to a predetermined operation characteristic to detect a phase-to-earth fault on the three-phase electric line. The predetermined operation characteristic, when presented on an admittance plane, defines a closed area such that the centre of the closed area is offset from the origin of the admittance plane towards a negative susceptance direction and/or towards a negative conductance direction. The described solution provides an operation function and characteristic, which can at the same time be valid for unearthed networks, high resistance earthed and/or compensated networks. Therefore, no change in the setting values is needed, if the earthing method of the electric network is changed.

Document EP0963025 describes a solution in which the operation sector of a directional earth-fault protection function is set preferably larger than 180 degrees. Such a characteristic is then valid in two of the following alternative neutral point treatment methods in an electricity distribution network: a network isolated from earth, a network earthed via resistance at the neutral point, a network provided with an arc-suppression coil of earth-fault current or a combination of the two previous ones. The described solution has an advantage that no direction angle setting of the relay is needed, even if the earthing method of the neutral point is changed. A possible drawback of the suggested solution is that it provides only a partial solution for automatic adaptation: only the directional condition is adapted but it lacks the automatic adaptation of possible other protection settings which may need to be changed, when the neutral earthing treatment changes.

BRIEF DESCRIPTION OF THE INVENTION

An object of the present invention is to provide a method and an apparatus for implementing the method so as to overcome the above problem or at least to alleviate the problem. The objects of the invention are achieved by a method, a computer program product and an apparatus which are characterized by what is stated in the independent claims. The preferred embodiments of the invention are disclosed in the dependent claims.

The invention is based on the idea of determining, on the basis of a comparison of a determined value for a directional phasor quantity with predetermined boundaries on a complex plane, a neutral earthing state of an electric network, and adapting one or more earth-fault protection settings on the basis of the determined neutral earthing state of the electric network.

An advantage of the invention is that the settings of the directional earth-fault protection of the electric network can be automatically adjusted according to the neutral earthing state of the electric network. Moreover, the invention does not necessarily require any auxiliary wiring, for example.

BRIEF DESCRIPTION OF THE DRAWINGS

In the following the invention will be described in greater detail by means of preferred embodiments with reference to the accompanying drawings, in which

> Figure 1 is an example of an operation characteristic according to an embodiment;
> Figure 2 is an example of an an electric network;
> Figure 3 is a diagram illustrating predetermined boundaries on a complex plane according to an embodiment; and
> Figure 4 is a diagram illustrating predetermined boundaries on a complex plane according to an embodiment.

DETAILED DESCRIPTION OF THE INVENTION

The application of the invention is not limited to any specific system, but it can be used in connection with various three-phase electric systems to adapt earth-fault protection settings.

The electric power system in connection with which the invention is implemented can be an electric transmission or distribution network or a component thereof, for example, and may comprise several feeders or sections. Moreover, the use of the invention is not limited to systems employing 50 Hz or 60 Hz fundamental frequencies or to any specific voltage level.

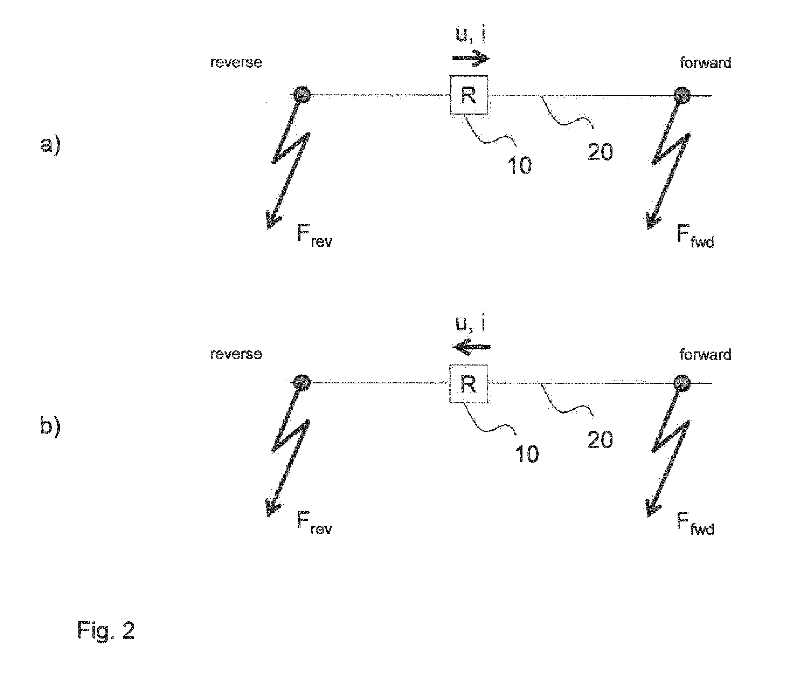

Figure 2 is a simplified diagram illustrating an example of an electric network in connection with which the invention can be applied. For the sake of simplicity, the figure shows only the components necessary for understanding the invention. The network may be e.g. a medium-voltage (e.g. 20 kV) distribution network. Figure 2 shows a protective directional relay unit (R) 10 located at an electric line 20. It should be noted that there may be any number of relay units, electric lines and other network elements in the electric network. In addition, the location of such relay units in the electric network may vary. The network is a three-phase network, although, for the sake of clarity, the phases are not shown in the figure. In the exemplary network of Figure 2, the functionality of the invention may be located in the relay unit 10. It is also possible that, for instance, only some measurements are performed at the location of the relay unit 10 and the results are then transmitted to some other unit or units (not shown in Figure 2) in another location for further processing. In other words, the relay unit 10 could be a mere measuring unit, while the functionality of the invention, or part of it, could be located in some other unit or units. An earth fault occurring in the electric network may be detected e.g. by the protective relay 10 or by other protective equipment associated with the electric network. The detection of an earth-fault in the network may be based on e.g. traditional residual overvoltage condition, but alternatively it may be based on a more sensitive method. Examples of such more sensitive methods may be based on monitoring not an absolute value of the residual voltage Uo, but a change of the residual voltage Uo (either magnitude and/or angle). Alternatively, earth-fault detection may be based on e.g. monitoring an estimated fault impedance (or admittance) of the system (or its change) as suggested e.g. in document WO98/20356. Other means for detecting an earth-fault may also be utilized. Typically said fault detection then releases the directional determination to decide whether the fault is located either in a reverse or in a forward direction. Figure 2 a) illustrates a situation, where the relay 10 is set to operate for faults in the forward direction ($F_{fwd}$). Faults in the reverse direction ($F_{rev}$) do not result in operation, but could be signalled e.g. for blocking purposes. Figure 2 b) illustrates a situation, where the relay 10 is set to operate for faults in the reverse direction ($F_{rev}$). Operation may be a tripping or a blocking action. Faults in the forward direction ($F_{fwd}$) in this case do not result in operation. In practice there may be simultaneously many instances of directional protection functions in operation, some of them providing tripping and some of them providing blocking.

Current and voltage values possibly needed in the different embodiments may be obtained by a suitable measuring arrangement including e.g. current and voltage transducers (not shown separately in the figures). In most of the existing protection systems, such values are readily available and thus the implementation of the various embodiments does not necessarily require any additional measuring arrangements.

According to an embodiment, after an earth fault has been detected in the electric network, a value for a directional phasor quantity is determined at a measuring point 10 in the three-phase electric network. The directional phasor quantity $\overline{DIR}$ may be based on e.g. any of the following electric phasor quantities (typically calculated at fundamental frequency):

- Impedance     $\overline{Z} = R + j * X$
- Admittance     $\overline{Y} = G + j * B$
- Power     $\overline{S} = P + j * Q$
- Current     $\overline{I} = I \cos(phi) + j * I \sin(phi)$

Where $\overline{Z}$ = Impedance, R = Resistance, X = Reactance, $\overline{Y}$ = Admittance, G = Conductance, B = Susceptance, $\overline{S}$ = Apparent power, P = Real power, Q = Reactive power, $\overline{I}$ = Current, Icos(phi) = Real-part of current, Isin(phi) = Imaginary part of current, phi = Phase angle difference between voltage and current, or reference current and current.

Furthermore, for deriving the directional phasor quantity, either phase quantities (phase current, phase-to-earth voltage, phase-to-phase voltage) or symmetrical components (positive sequence, negative sequence or zero-sequence component) can be applied.

For the calculation of $\overline{DIR}$ phasor, a preferable requirement is that a value used for the calculation exceeds a minimum threshold, i.e. the angle of $\overline{DIR}$ can be reliably measured. The minimum threshold may be e.g. 0.5% of a nominal value or some other suitable threshold value. An admittance value has the advantage that it is least affected by fault resistance. In addition, the directional phasor quantity $\overline{DIR}$ may be either based on discrete or cumulative values. A cumulative value has the advantage that it provides a more stable fault direction indication during disturbances and non-sinusoidal signals e.g. in an intermittent earth-fault. A cumulative value of $\overline{DIR}$ may be formed as a cumulative phasor sum of at least two discrete values of the electric phasor quantity in question.

After the value for the directional phasor quantity $\overline{DIR}$ has been determined, the determined value for the directional phasor quantity is compared with predetermined boundaries on a complex plane.

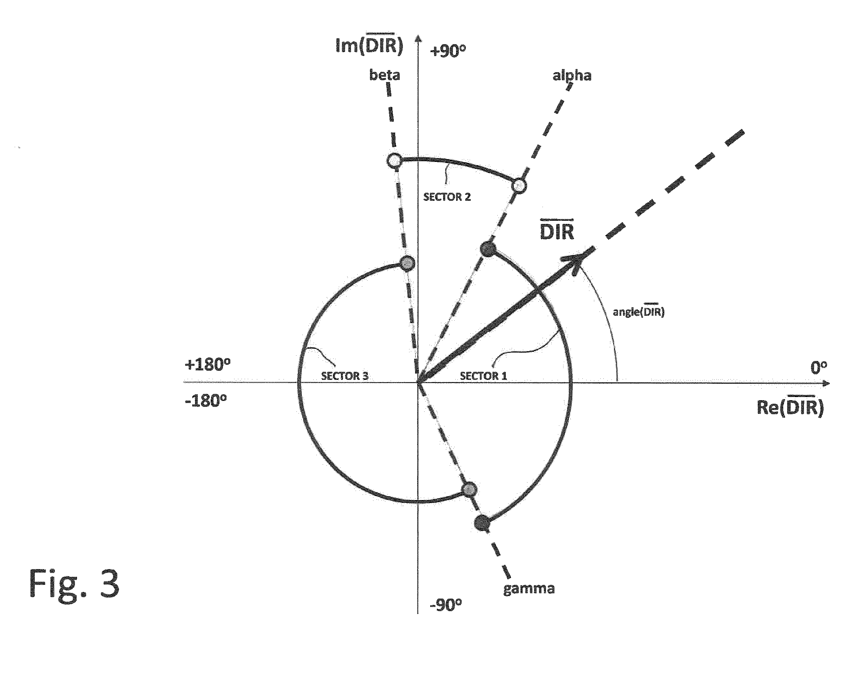

According to an embodiment the directional plane of a directional earth-fault function presented on a complex-plane with a real axis and an imaginary axis comprises two or more predetermined boundaries. The predetermined boundaries preferably define at least two sectors on the complex plane, wherein each sector preferably corresponds to a certain neutral earthing state of the electric network. An example of this is given in Figure 3 which shows three boundaries, *alpha*, *beta* and *gamma* which divide the complex plane into three sectors (1 to 3). In the example of Figure 3, the directional phasor quantity $\overline{DIR}$ is located in sector 1. Moreover, in the example of Figure 3, sector 1 is based on the position of the directional phasor $\overline{DIR}$ during an inside fault in a compensated system or a resistance earthed system. Sector 2 is based on a position of directional phasor $\overline{DIR}$ during an inside fault in an unearthed system (i.e. an unearthed system or when the coil or an earthing resistor is switched off). Sector 3 is based on a position of the directional phasor $\overline{DIR}$ during an outside fault. This fault direction (= reverse) is typically only used for indication purposes, but in some cases also for blocking purposes. As a numerical example, the following sectors and settings could be applied in the three-sector example of Figure 3:

- Sector 1: e.g. from +70 deg. to -85 deg. This section represents an inside fault in case of compensated or resistance earthed system.

- Sector 2: e.g. from +70 deg. to +95 deg. This section represents an inside fault in case of unearthed system.

- Sector 3: e.g. from +95 deg. to -85 deg. This section represents an outside fault regardless of system neutral earthing.

According to an embodiment, a neutral earthing state of the electric network is then determined on the basis of the comparison, and one or more earth-fault protection settings are adapted on the basis of the determined neutral earthing state of the electric network. In other words, when the neutral earthing state of the system is determined, the settings of the earth-fault protection of the system can be adapted to correspond to the determined neutral earthing state. Earth-fault protection settings that are adapted may include e.g. one or more of the following:

If the directional earth-fault protection function is Directional earth-fault protection function DEFxPDEF:

* Operation mode: IoSin (operation is based on monitoring the reactive part of Io, applicable in an unearthed network) or IoCos (operation is based on monitoring the resistive part of Io, applicable in a compensated network)
* Residual current start value (start value of residual current (resistive or reactive part of Io)
* Operate time delay (a settable operation delay)
* Residual voltage start value

If the directional earth-fault protection function is Directional earth-fault protection function DEFxPDEF:

* Operation mode: Phase angle
* Characteristic angle: -90 deg. or 0 deg.
* Residual current start value (amplitude of Io)
* Operate time delay
* Residual voltage start value

If the directional earth-fault protection function is Admittance-based earth fault protection function EFPADM:

* Operation mode: Bo (operation is based on monitoring the reactive part of Yo = Bo (susceptance), applicable in an unearthed network) or Go (operation is based on monitoring the resistive part of Yo = Go (conductance), applicable in a compensated network)
* Admittance Clc mode: Normal or Delta (Term "Normal" refers to an admittance calculation method, where the admittance is calculated by dividing the Io-phasor with Uo-phasor during the fault. The term "Delta" refers to an admittance calculation method, where the admittance is calculated by utilizing "delta" quantities i.e. phasors representing the change due to a fault, and then dividing the "delta Io"-phasor with "delta Uo"-phasor).
* Operate time delay
* Residual voltage start value

If the directional earth-fault protection function is Wattmetric/Varmetric earth-fault protection function WPWDE:

* Characteristic angle: -90 deg. (Varmetric-mode) or 0 deg. (Wattmetric-mode)
* Residual power start value (start value of a residual power (resistive or reactive part of So (residual power)))
* Residual current start value
* Operate time delay
* Residual voltage start value

In general terms, the operate thresholds of a directional earth-fault protection function should preferably be adapted so that in case the determined neutral earthing state is an unearthed network, the operate thresholds should be related to imaginary parts of operate quantities (e.g. currrent, power or admittance) such as Iosin, Qo or Bo. In case the determined neutral earthing state is a compensated network, the operate thresholds should be related to real parts of operate quantities (e.g. currrent, power or admittance), such as Iocos, Po or Go.

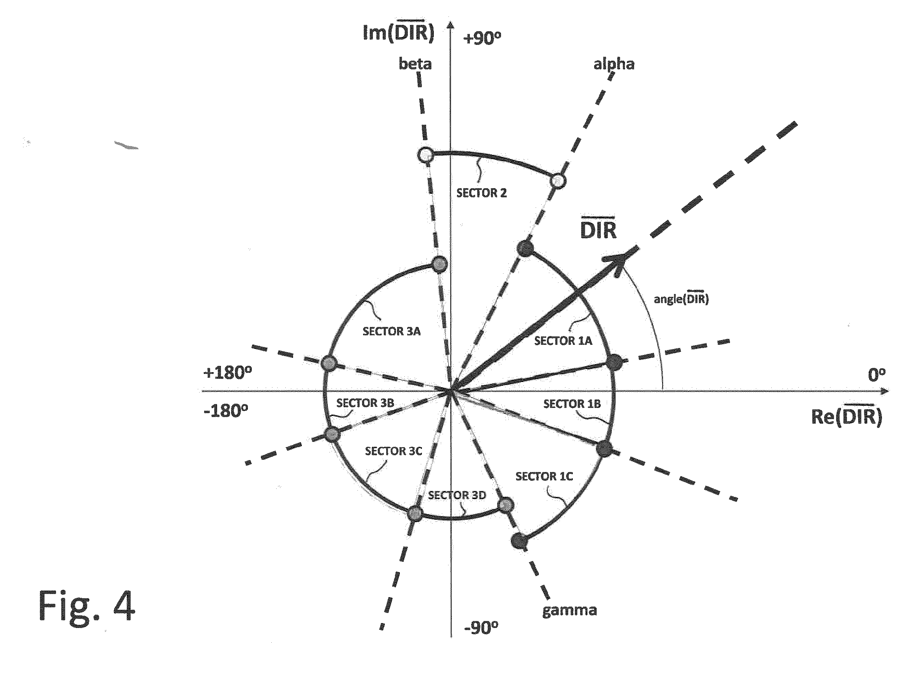

Figure 4 shows another example of a diagram illustrating predetermined boundaries on a complex plane according to an embodiment. In the example of Figure 4, the directional plane is divided into eight sectors. Sectors 1A, 1B and 1C represent inside faults in undercompensated, tuned and overcompensated networks, respectively. Sector 2 represents an inside fault in an unearthed system (i.e. an unearthed system or when the coil or an earthing resistor is switched off) and a system with only distributed compensation in feeders (no central coil in use or it is switched off). In case distributed compensation is applied in the system, Sectors 3A, 3B and 3C represent outside faults in overcompensated, tuned and undercompensated feeders, respectively. Sector 3D represents an outside fault in case a distributed compensation coil is disconnected or it is not applied.

As a numerical example, the following sectors and settings could be applied:

• Sector 1A: From +70 deg. to +10 deg. represents an inside fault in an undercompensated system
• Sector 1B: From +10 deg. to -10 deg. represents an inside fault in a tuned system
• Sector 1C: From -10 deg. to -85 deg. represents an inside fault in an undercompensated system
• Sector 2: From +70 deg. to +95 deg. This section represents an inside fault in an unearthed system.
• Sector 3A: From +95 deg. to +170 deg. represents an outside fault in a locally overcompensated feeder.
• Sector 3B: From +170 deg. to -170 deg. represents an outside fault in a locally tuned feeder.
• Sector 3C: From -100 deg. to -170 deg. represents an outside fault in a locally undercompensated feeder.
• Sector 3D: From -85 deg. to -100 deg. represents an outside fault in case the distributed compensation coil is disconnected or it is not applied.

The number of sectors, sector widths and angles can be derived from the fundamental theory of earth fault in high-impedance earthed networks as described in the following. A minimum of two sectors is required in order to identify different neutral earthing conditions and to adapt the earth-fault protection settings accordingly. The following provides a basic guideline on how sectors may be selected, i.e. angles *alpha*, *beta* and *gamma* in Figure 3. This is based on the fundamental theory of earth fault in high-impedance earthed network utilizing the theory of admittances. The angles *alpha, beta* and *gamma* may be based on the theoretical value for the angle of $\overline{Y}_o$ in different fault scenarios.

The result of admittance calculation when the fault is located outside a protected feeder:

$$\overline{Y}_o = -\left(\left[G_{Fdtot} + G_{cDST\_Fd}\right] + j \cdot \left[B_{Fdtot} - B_{cDST\_Fd}\right]\right)$$

Where

$G_{Fdtot}$ is the total phase-to-earth conductance of the feeder
$G_{cDST\_Fd}$ is the total phase-to-earth conductance of the distributed coils located at the feeder
$B_{Fdtot}$ is the total phase-to-earth susceptance of the feeder
$B_{cDST\_Fd}$ is the total phase-to-earth susceptance of the distributed coils located at the feeder

The result of admittance calculation when the fault is located inside the protected feeder:

$$\overline{Y}_o = \left(\left[G_{Bgtot} + G_{cCC} + G_{cDST\_Bg}\right] + j \cdot \left[(B_{Network} \cdot (1 - K) - B_{Fdtot} - B_{cDST\_Bg}\right]\right)$$

Where

$G_{Bgtot}$ is the total phase-to-earth conductance of the background network
$G_{cCC}$ is the phase-to-earth conductance of the compensation coil located at a substation
$G_{cDST\_Bg}$ is the total phase-to-earth conductance of the distributed coils located at the background network
$B_{Network}$ is the total phase-to-earth susceptance of the network = $B_{Fdtot}$ + $B_{Bgtot}$
$B_{Bgtot}$ is the total phase-to-earth susceptance of the background network

K is the compensation degree of the compensation coil located at the *substation*, $K = {B_{cCC}}\big/{B_{Network}}$

When K equals 1.0, the network is said to be fully compensated. In case K < 1, the network is said to be undercompensated. On the other hand, in case K > 1, the network is said to be overcompensated.
$B_{cCC}$ is the phase-to-earth susceptance of the compensation coil located at the substation

Angle *gamma*:

The value for angle *gamma* is preferably based on two conditions:

1. The fault is located outside the protected feeder assuming the feeder includes no distributed coils. Maximum practical measurement errors in the measurement chain (voltage transformer, current transformer, relay) should preferably be considered, which will turn the phasor counter-clockwise.
2. The fault is located inside the protected feeder assuming maximum practical overcompensation.

A typical value for angle *gamma* is between -80 and -90 degrees.

Angle *beta*:

The value for angle beta is preferably based on two conditions:

System without distributed compensation:

1. The fault is located inside the protected feeder, assuming an unearthed network. Maximum practical measurement errors in the measurement chain (voltage transformer, current transformer, relay) should be considered, which will turn the phasor counter-clockwise.

In addition, in case the system has distributed compensation:

2. The fault is located outside the protected feeder, assuming maximum practical overcompensation of the feeder.

A typical value for angle *beta* is between +90 and +100 degrees.

Angle *alpha*:

The value for angle *alpha* is preferably based on two conditions:

1. The fault is located inside the protected feeder, assuming an unearthed network. Maximum practical resistive (shunt) losses should be considered, which will turn the phasor clockwise.
2. The fault is located inside the protected feeder, assuming maximum practical undercompensation.

A typical value for angle *alpha* is between +60 and +80 degrees.

An apparatus according to any one of the above embodiments, or a combination thereof, may be implemented as a single unit or as two or more units that are configured to implement the functionality of the various embodiments. Here the term 'unit' refers generally to a physical or logical entity, such as a physical device or part thereof or a software routine. One or more of these units may reside in the protective relay unit 10, for example. More generally, the above embodiments can be realized in an IED (Intelligent Electronic Device) residing in the electric network.

An apparatus according to any one of the embodiments may be implemented by means of a computer or corresponding digital signal processing equipment provided with suitable software, for example. Such a computer or digital signal processing equipment preferably comprises at least a working memory (RAM) providing a storage area for arithmetical operations, such as program instructions, and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention further preferably comprises suitable input means for receiving e.g. measurement and/or control data, and output means for outputting e.g. fault alarms and/or control data e.g. for controlling protection equipment such as switches, disconnectors and circuit-breakers. It is also possible to use a specific integrated circuit or circuits, and/or discrete components and devices for implementing the functionality according to any one of the embodiments.

The invention can be implemented in existing system elements, such as various protective relays or similar devices, or by using separate dedicated elements or devices in a centralized or distributed manner.

Present protective devices for electric systems, such as protective relays or generally IEDs, typically comprise processors and memory that can be utilized in the functions according to embodiments of the invention. Thus, all modifications and configurations required for implementing an embodiment of the invention e.g. in existing protective devices may be performed as software routines, which may be implemented as added or updated software routines. If the functionality of the invention is implemented by software, such software can be provided as a computer program product comprising computer program code which, when run on a computer, causes the computer or corresponding arrangement to perform the functionality according to the invention as described above. Such a computer program code may be stored or generally embodied on a computer readable medium, such as suitable memory means, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept may be implemented in various ways. The invention and its embodiments are not limited to the examples described above but may vary within the scope of the claims.

**Claims**

1. A method for adapting earth-fault protection settings in a three-phase electric network, the method comprising:

   detecting an earth fault in the three-phase electric network;

determining, after the earth fault has been detected in the electric network, a value for a directional phasor quantity ($\overline{DIR}$) at a measuring point (10) in the three-phase electric network; and

comparing the determined value for the directional phasor quantity ($\overline{DIR}$) with predetermined boundaries on a complex plane, **characterized in that** the method comprises:

determining, on the basis of the comparison, a neutral earthing state of the electric network; and

adapting one or more earth-fault protection settings on the basis of the determined neutral earthing state of the electric network.

2. A method according to claim 1, **characterized in that** the directional phasor quantity ($\overline{DIR}$) is one of the following: impedance, admittance, power, or current.

3. A method according to claim 1, or 2, **characterized in that** the predetermined boundaries define sectors on the complex plane, wherein each sector corresponds to a certain neutral earthing state of the electric network.

4. A method according to claim 1, 2 or 3, **characterized in that** the detection of the earth fault in the three-phase electric network is based on monitoring at least one of the following: a value of a residual voltage of the electric network, a change of the value of the residual voltage of the electric network, a value of an estimated fault impedance or admittance, a change of the value of the estimated fault impedance or admittance.

5. A method according to any one of claims 1 to 4, **characterized in that** the one or more earth-fault protection settings comprise one or more settings of one of the following: directional earth-fault protection, admittance-based earth-fault protection, wattmetric/varmetric earth-fault protection.

6. A computer program product comprising computer program code, wherein the execution of the program code in a computer causes the computer to carry out the steps of the method according to any one of claims 1 to 5.

7. An apparatus for adapting earth-fault protection settings in a three-phase electric network, the apparatus (10) comprising:

means for determining a value for a directional phasor quantity at a measuring point in the three-phase electric network after an earth fault has been detected in the three-phase electric network; and

means for comparing the determined value for the directional phasor quantity with predetermined boundaries on a complex plane, **characterized in that** the apparatus (10) comprises:

means for determining, on the basis of the comparison, a neutral earthing state of the electric network; and

means for adapting one or more earth-fault protection settings on the basis of the determined neutral earthing state of the electric network.

8. An apparatus according to claim 7, **characterized in that** the directional phasor quantity is one of the following: impedance, admittance, power, or current.

9. An apparatus according to claim 7 or 8, **characterized in that** the apparatus comprises means for detecting an earth fault in the three-phase electric network.

10. An apparatus according to claim 9, **characterized in that** the means for detecting the earth fault in the three-phase electric network are adapted to the detect the earth fault in the three-phase electric network on the basis of monitoring at least one of the following: a value of a residual voltage of the electric network, a change of the value of the residual voltage of the electric network, a value of an estimated fault impedance or admittance, a change of the value of the estimated fault impedance or admittance.

11. An apparatus according to any one of claims 7 to 10, **characterized in that** the predetermined boundaries define sectors on the complex plane, wherein each sector corresponds to a certain neutral earthing state of the electric network.

12. An apparatus according to any one of claims 7 to 11, **characterized in that** the one or more earth-fault protection settings comprise one or more settings of one of the following: directional earth-fault protection, admittance-based earth-fault protection, wattmetric/varmetric earth-fault protection.

**13.** An apparatus according to any one of claims 7 to 12, **characterized in that** the apparatus comprises a protective relay.

**Patentansprüche**

**1.** Verfahren zum Anpassen von Erdschlussschutzeinstellungen in einem Dreiphasen-Stromnetzwerk, wobei das Verfahren aufweist:

Erkennen eines Erdschlusses in einem Dreiphasen-Stromnetzwerk;
nach dem Erkennen eines Erdschlusses in dem Dreiphasen-Stromnetzwerk, Bestimmen eines Wertes einer Richtungszeigergröße ($\overline{DIR}$) an einer Messstelle (10) in dem Dreiphasen-Stromnetzwerk; und
Vergleichen des bestimmten Werts der Richtungszeigergröße ($\overline{DIR}$) mit vorbestimmten Grenzen auf einer komplexen Ebene, **dadurch gekennzeichnet, dass** das Verfahren aufweist:

Bestimmen eines neutralen Erdungszustands des Stromnetzwerks auf der Basis des Vergleichs; und
Anpassen einer oder mehrerer Erdschlussschutzeinstellungen auf der Basis des bestimmten neutralen Erdungszustands des Stromnetzwerks.

**2.** Verfahren nach Anspruch 1, **dadurch gekennzeichnet, dass** die Richtungszeigergröße ($\overline{DIR}$) eine der folgenden ist: Impedanz, Admittanz, Leistung oder Strom.

**3.** Verfahren nach Anspruch 1 oder 2, **dadurch gekennzeichnet, dass** die vorbestimmten Grenzen Sektoren auf der komplexen Ebene definieren, wobei jeder Sektor einem gewissen neutralen Erdungszustand des Stromnetzwerks entspricht.

**4.** Verfahren nach Anspruch 1, 2 oder 3, **dadurch gekennzeichnet, dass** die Erkennung des Erdschlusses in dem Dreiphasen-Stromnetzwerk auf der Überwachung mindestens eines der Folgenden basiert: der Wert der Restspannung des Stromnetzwerks, die Veränderung des Werts der Restspannung des Stromnetzwerks, der Wert der geschätzten Fehlerimpedanz oder -admittanz, die Veränderung des Werts der geschätzten Fehlerimpedanz oder -admittanz.

**5.** Verfahren nach einem der Ansprüche 1 bis 4, **dadurch gekennzeichnet, dass** die eine oder die mehreren Erdschlussschutzeinstellungen eine oder mehrere Einstellungen eines der Folgenden aufweist: richtungsabhängiger Erdschlussschutz, admittanzbasierter Erdschlussschutz, Wattmetrischer/varmetrischer Erdschlussschutz.

**6.** Computerprogrammprodukt mit einem Computerprogrammcode, wobei das Ausführen des Programmcodes auf einem Computer den Computer veranlasst, die Schritte gemäß den Ansprüchen 1 bis 5 auszuführen.

**7.** Vorrichtung zum Anpassen von Erdschlussschutzeinstellungen in einem Dreiphasen-Stromnetzwerk, wobei die Vorrichtung (10) aufweist:

eine Einrichtung zum Bestimmen eines Werts einer Richtungszeigergröße an einer Messstelle in dem Dreiphasen-Stromnetzwerk nach dem Erkennen eines Erdschlusses in dem Dreiphasen-Stromnetzwerk; und
eine Einrichtung zum Vergleichen des bestimmten Werts der Richtungszeigergröße mit vorbestimmten Grenzen auf einer komplexen Ebene,
**dadurch gekennzeichnet, dass** die Vorrichtung (10) aufweist:

eine Einrichtung zum Bestimmen eines neutralen Erdungszustands des Stromnetzwerks auf der Basis des Vergleichs; und
eine Einrichtung zum Anpassen einer oder mehrerer Erdschlussschutzeinstellungen auf der Basis des bestimmten neutralen Erdungszustands des Stromnetzwerks.

**8.** Vorrichtung nach Anspruch 7, **dadurch gekennzeichnet, dass** die Richtungszeigergröße eine der folgenden ist: Impedanz, Admittanz, Leistung oder Strom.

**9.** Vorrichtung nach Anspruch 7 oder 8, **dadurch gekennzeichnet, dass** die Vorrichtung eine Einrichtung zum Erkennen eines Erdschlusses in dem Dreiphasen-Stromnetzwerk aufweist.

**10.** Vorrichtung nach Anspruch 9, **dadurch gekennzeichnet, dass** die Einrichtung zum Erkennen des Erdschlusses in dem Dreiphasen-Stromnetzwerk in der Lage sind, den Erdschluss in dem Dreiphasen-Stromnetzwerk auf der Basis der Überwachung mindestens eines der Folgenden zu erkennen: der Wert der Restspannung des Stromnetzwerks, die Veränderung des Werts der Restspannung des Stromnetzwerks, der Wert der geschätzten Fehlerimpedanz oder -admittanz, die Veränderung des Werts der geschätzten Fehlerimpedanz oder -admittanz.

**11.** Vorrichtung nach einem der Ansprüche 7 bis 10, **dadurch gekennzeichnet, dass** die vorbestimmten Grenzen Sektoren auf der komplexen Ebene definieren, wobei jeder Sektor einem gewissen neutralen Erdungszustand des Stromnetzwerks entspricht.

**12.** Vorrichtung nach einem der Ansprüche 7 bis 11, **dadurch gekennzeichnet, dass** die eine oder die mehreren Erdschlussschutzeinstellungen eine oder mehrere Einstellungen eines der Folgenden aufweist: richtungsabhängiger Erdschlussschutz, admittanzbasierter Erdschlussschutz, Wattmetrischer/varmetrischer Erdschlussschutz.

**13.** Vorrichtung nach einem der Ansprüche 7 bis 12, **dadurch gekennzeichnet, dass** die Vorrichtung ein Schutzrelais aufweist.

**Revendications**

**1.** Procédé pour adapter des paramètres de protection contre les défauts de terre dans un réseau électrique triphasé, le procédé comprenant :

- la détection d'un défaut de terre dans un réseau électrique triphasé ;
- la détermination, après que le défaut de terre a été détecté dans le réseau électrique, d'une valeur pour une quantité de phaseur directionnel ($\overline{DIR}$) à un point de mesure (10) dans le réseau électrique triphasé ; et
- la comparaison de la valeur déterminée pour la quantité de phaseur directionnel ($\overline{DIR}$) avec des limites prédéterminées dans un plan complexe, **caractérisé en ce que** le procédé comprend :
- la détermination, sur la base de la comparaison, d'un état de mise à la terre du neutre du réseau électrique ; et
- l'adaptation d'un ou plusieurs paramètres de protection contre les défauts de terre sur la base de l'état de mise à la terre du neutre déterminé du réseau électrique.

**2.** Procédé selon la revendication 1, **caractérisé en ce que** la quantité de phaseur directionnel ($\overline{DIR}$) est l'une des suivantes : impédance, admittance, puissance, ou courant.

**3.** Procédé selon la revendication 1, ou 2, **caractérisé en ce que** les limites prédéterminées définissent des secteurs dans le plan complexe, dans lequel chaque secteur correspond à un certain état de mise à la terre du neutre du réseau électrique.

**4.** Procédé selon la revendication 1, 2 ou 3, **caractérisé en ce que** la détection du défaut de terre dans le réseau électrique triphasé est basé sur la surveillance d'au moins un parmi : une valeur de tension résiduelle du réseau électrique, un changement de la valeur de la tension résiduelle du réseau électrique, une valeur d'une admittance ou impédance de défaut estimée, un changement de la valeur de l'admittance ou de l'impédance estimée du défaut.

**5.** Procédé selon l'une quelconque des revendications 1 à 4, **caractérisé en ce que** le ou plusieurs paramètre(s) de protection contre les défauts de terre comprend un ou plusieurs paramètres parmi un des suivants: protection contre les défauts de terre directionnels, protection contre les défauts de terre sur la base de l'admittance, protection contre les défauts de terre varmétriques/wattmétriques.

**6.** Produit de programme d'ordinateur comprenant un code de programme d'ordinateur, dans lequel l'exécution du code de programme dans un ordinateur provoque la réalisation des étapes du procédé selon l'une quelconque des revendications 1 à 5.

**7.** Appareil pour adapter des paramètres de protection contre les défauts de terre dans un réseau électrique triphasé, l'appareil comprenant :

- des moyens pour déterminer une valeur pour une quantité de phaseur directionnel à un point de mesure dans le réseau électrique triphasé après que le défaut de terre a été détecté dans le réseau électrique ; et

- des moyens pour comparer la valeur déterminée pour la quantité de phaseur directionnel avec des limites prédéterminées dans un plan complexe, **caractérisé en ce que** l'appareil (10) comprend :

- des moyens pour déterminer, sur la base de la comparaison, un état de mise à la terre du neutre du réseau électrique ; et

- des moyens pour adapter un ou plusieurs paramètres de protection contre les défauts de terre sur la base de l'état de mise à la terre du neutre déterminé du réseau électrique.

8. Appareil selon la revendication 7, **caractérisé en ce que** la quantité de phaseur directionnel est l'une des suivantes : impédance, admittance, puissance, ou courant.

9. Appareil selon la revendication 7 ou 8, **caractérisé en ce que** l'appareil comprend des moyens pour détecter un défaut de terre dans le réseau électrique triphasé.

10. Appareil selon la revendication 9, **caractérisé en ce que** les moyens pour détecter le défaut de terre dans le réseau électrique triphasé sont adaptés pour la détection du défaut de terre dans le réseau électrique triphasé sur la base de la surveillance d'au moins un parmi : une valeur de tension résiduelle du réseau électrique, un changement de la valeur de la tension résiduelle du réseau électrique, une valeur d'une admittance ou impédance estimée du défaut, un changement de la valeur de l'admittance ou de l'impédance de défaut estimée.

11. Appareil selon l'une quelconque des revendications 7 à 10, **caractérisé en ce que** les limites prédéterminées définissent des secteurs dans le plan complexe, dans lequel chaque secteur correspond à un certain état de mise à la terre du neutre du réseau électrique.

12. Appareil selon l'une quelconque des revendications 7 à 11, **caractérisé en ce que** le ou plusieurs paramètre(s) de protection contre les défauts de terre comprend un ou plusieurs paramètres parmi un des suivants: protection contre les défauts de terre directionnels, protection contre les défauts de terre sur la base de l'admittance, protection contre les défauts de terre varmétriques/wattmétriques.

13. Appareil selon l'une quelconque des revendications 7 à 12, **caractérisé en ce que** l'appareil comprend un relais de protection.

Fig. 1

a)

reverse

u, i

→

R

forward

F$_{rev}$

10

20

F$_{fwd}$

b)

reverse

u, i

←

R

forward

F$_{rev}$

10

20

F$_{fwd}$

Fig. 2

Fig. 3

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2192416 A
- EP 0963025 A

- WO 9820356 A